# EUROPEAN PATENT APPLICATION

(11) **EP 2 426 818 A2**
(43) Date of publication of application: **07.03.2012**
(21) Application number: 11179863.3
(22) Date of filing: 02.09.2011
(51) Int. Cl.: H03H 3/02, H03H 9/19, H03H 9/17, H03H 9/10, H03H 9/05

(54) **Method of fabricating a resonator, resonator, and oscillator**

(30) Priority: 06.09.2010 JP 2010199257
(71) Applicant: FUJITSU LIMITED, Kawasaki-shi, Kanagawa 211-8588 (JP)
(72) Inventor: Kishi, Masakazu, Kanagawa, 211-8588 (JP); Itoh, Masayuki, Kanagawa, 211-8588 (JP)
(74) Representative: HOFFMANN EITLE

(57) **Abstract**

There is provided a method of fabricating a resonator, the method includes, joining a vibrating plate with a substrate at a first surface thereof, grinding a surface of the vibrating plate joined with the substrate, forming an electrode on the ground surface of the vibrating plate, and etching electively a region at a second surface of the substrate, where the second surface is opposite to the first surface and the region is corresponding to a position of the electrode.

## Description

### FIELD

The embodiments discussed herein are related to a resonator, a method of fabricating a resonator, and an oscillator having the resonator.

### BACKGROUND

With increase in frequencies of communication apparatuses and increase in operating frequencies of microcomputers, frequencies of oscillators are also increased. In the oscillators, an AT-cut crystal resonator is suitably used, since the frequency-temperature characteristic is stabilized and the frequency changes in response to thickness to thereby easily adjust the oscillation frequency.

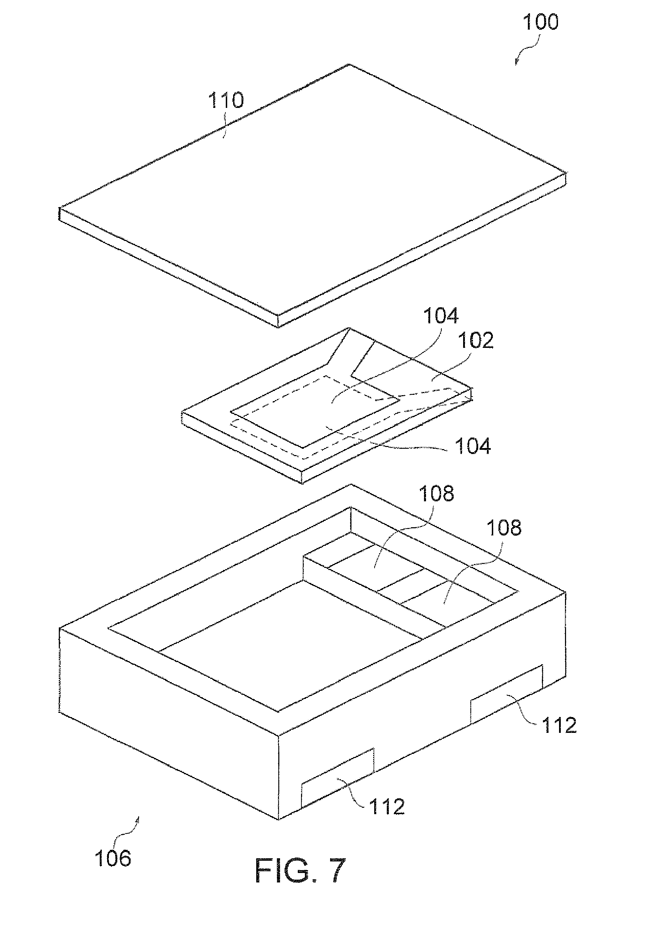

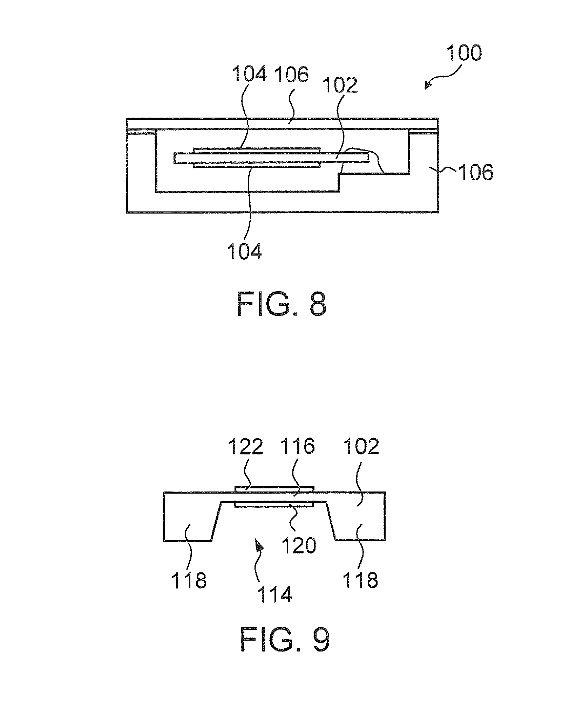

FIGs. 7 and 8 are diagrams illustrating a structure of a resonator that is an existing AT-cut crystal resonator. In the resonator 100 illustrated in FIG. 7, exciting electrodes 104 are formed as thin films of Au or the like on both sides of an AT-cut crystal vibrating plate (hereinafter, referred to as vibrating plate) 102, and the vibrating plate 102 is fixed at a predetermined position in a ceramic package 106 by a conductive adhesive or the like such that the exciting electrodes 104 on the vibrating plate 102 are connected to connection pads 108 of the ceramic package 106. The vibrating plate 102 is sealed in the ceramic package 106 by a lid 110. In this manner, as illustrated in FIG. 8, the resonator 100 having the vibrating plate 102 provided in the ceramic package 106 is produced. In an outside bottom surface of the ceramic package 106 of the resonator 100, connection terminals 112 (see FIG. 7) are provided so as to extend from the connection pads 108. Thus, the resonator 100 is mounted on a printed wiring board (not illustrated) on which an oscillation circuit and the like are provided, such that the connection terminals 112 are connected to connection pads on the printed wiring board. Thus, an oscillator having the resonator 100 is formed.

Meanwhile, the oscillation frequency f_{O} of the vibrating plate 102 is determined approximately by the thickness of the vibrating plate 102 as follows:

fo = 1.67 x n/t [MHz],

where n denotes an overtone order (an odd number equal to or more than 1) and t denotes the thickness [mm] of the vibrating plate 102. For example, when the basic frequency of n = 1 is 50 MHz, the thickness of the vibrating plate 102 is 33 µm. The operation of thinning the vibrating plate 102 to about several tens of micrometers is performed by mechanical grinding. According to increase in the oscillation frequency in recent years, for example, in order to set the oscillation frequency to 300 MHz, the vibrating plate 102 is ground to a thickness of about 10 µm. However, it is difficult to stably perform mechanical grinding such that such a thickness is ensured, and thus chemical etching is used.

For example, a high-frequency piezoelectric resonator as illustrated in FIG. 9 in which a center portion 114 of a vibrating plate 102 is etched is known (see, for example, Japanese Laid-open Patent Publication No. 11-205076). Specifically, in producing the high-frequency piezoelectric resonator, one main surface of a piezoelectric substrate that is the vibrating plate 102 is recessed by using photo etching or the like, an electrode 120 is formed on the recessed portion side of the piezoelectric substrate in which a very thin portion 116 and an annular portion 118 supporting the very thin portion 116 are integrally formed, a small electrode 122 is placed on the flat side of the piezoelectric substrate, and the frequency of the vibrating portion is measured. As necessary, finishing is performed by dry etching such that the frequency of the vibrating portion becomes a predetermined frequency.

However, it is difficult to stably mass-produce the above high-frequency piezoelectric resonator as a resonator in which the thickness of the vibrating plate 102 is equal to or less than 3 µm and which has an oscillation frequency of about 600 MHz. In other words, with the configuration of the above high-frequency piezoelectric resonator, it is difficult to stably produce a resonator having an oscillation frequency higher than those of existing resonators.

### SUMMARY

Accordingly, it is an object in one aspect of the invention to provide a resonator producing method that allows a resonator to be stably fabricated with a configuration different from that of the existing art, a resonator, and an oscillator.

According to an aspect of the invention, a method of fabricating a resonator includes joining a vibrating plate with a substrate at a first surface of the substrate, grinding a surface of the vibrating plate joined with the substrate, forming an electrode on the ground surface of the vibrating plate, and etching electively a region at a second surface of the substrate, where the second surface is opposite to the first surface and the region is corresponding to a position of the electrode.

According to another aspect of the invention, a resonator includes a substrate having a first and a second surfaces opposite to each other, the first surface including a recess, a vibrating plate bonded to a region of the second surface, the region formed at a position opposing to a position of the recess; and an electrode formed on the vibrating plate, wherein a portion of the substrate at a bottom of the recess is made to be electrically conductive and serves as an opposite electrode opposing to the electrode.

### BRIEF DESCRIPTION OF DRAWINGS

FIG. 1 is a diagram illustrating a configuration of a main portion of a resonator according to a first embodiment;

FIGs. 2A to 2E are diagrams illustrating a method of producing the resonator;

FIGs. 3A to 3D are diagrams illustrating monitoring that is performed when etching a substrate;

FIG. 4 is a diagram illustrating an oscillator having the resonator according to the first embodiment;

FIG. 5 is a diagram illustrating a packaged oscillator having the resonator according to the first embodiment;

FIG. 6 is a diagram illustrating a configuration of a main portion of a resonator according to a second embodiment;

FIG. 7 is a diagram illustrating an existing resonator;

FIG. 8 is a diagram illustrating a cross section of the existing resonator; and

FIG. 9 is a diagram illustrating a cross section of another existing resonator.

### DESCRIPTION OF EMBODIMENTS

Hereinafter, a method of producing a resonator device, a resonator, and an oscillator, according to the present invention, will be described.

(First embodiment)

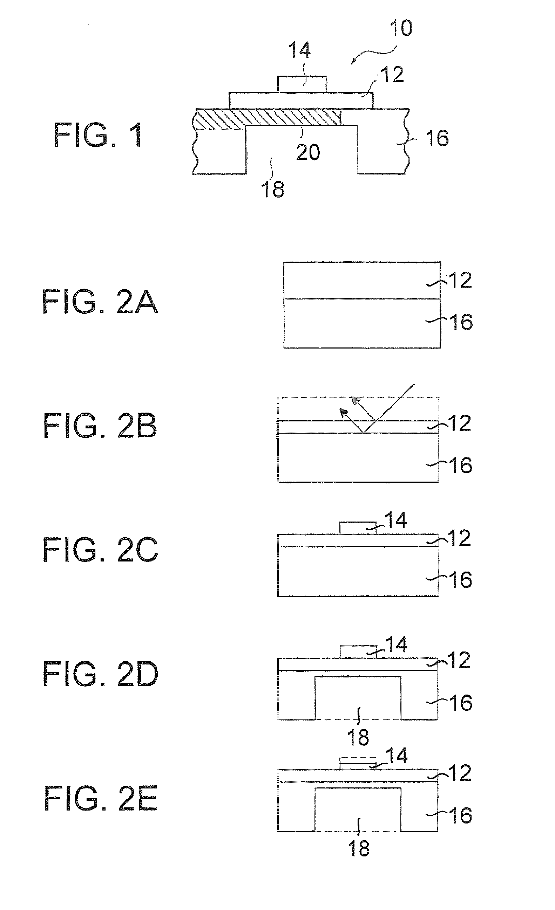

FIG. 1 is a diagram illustrating a configuration of a main portion of a resonator according to a first embodiment. A resonator 10 includes an AT-cut crystal (quartz) vibrating plate (hereinafter, referred to as vibrating plate) 12, an electrode 14, and a Si substrate 16. The vibrating plate 12 is provided on the Si substrate 16, and the electrode 14 is provided on the vibrating plate 12.

Specifically, a recess 18 is provided in one surface of the Si substrate 16. On a surface of the Si substrate 16 that is opposite to the surface thereof in which the recess 18 is provided, the vibrating plate 12 is joined in a region corresponding to the recess 18. The electrode 14 is provided on a surface of the vibrating plate 12. Therefore, the recess 18 and the electrode 14 are provided so as to face each other across the vibrating plate 12. Further, a region 20 of a substrate thin portion of the Si substrate 16 at the bottom of the recess 18 is made conductive to be an opposite electrode that is opposed to the electrode 14.

The vibrating plate 12 is joined to the Si substrate 16 by anode bonding. The vibrating plate 12 is a crystal vibrating plate that includes SiO₂ as a principal component, and thus the vibrating plate 12 may easily be bonded anodically to the Si substrate 16. The thickness of the vibrating plate 12 is, for example, equal to or less than 3 µm. The electrode 14 is a thin film made of Au, Ag, Al, or the like, and is formed by sputtering or vapor deposition. The thickness of the electrode 14 is several nanometers to 10 nanometers. The reason why the electrode 14 is very thin as described above is that by reducing the mass of the electrode 14 provided on the vibrating surface of the vibrating plate 12 within a range that allows the electrode 14 to serve as an electrode, a decrease in the oscillation frequency of the vibrating plate 12 is suppressed. The electrode 14 is connected to a terminal provided on the Si substrate 16, via a connection line not illustrated.

The region 20 of the Si substrate 16 is made conductive by performing impurity doping on the Si substrate 16, and thus serves as an opposite electrode that is opposed to the electrode 14. The region 20 is connected to a terminal provided on the Si substrate 16, via a connection line not illustrated. The region 20 of the Si substrate 16 serves as an electrode of the resonator 10. The region 20 serving as an electrode is located in the substrate thin portion of the Si substrate 16 that is thin due to the recess 18, and thus may suppress a decrease in the oscillation frequency of the vibrating plate 12. Such a recess 18 is formed by dry etching. For example, CF₄ is introduced into a chamber having a pressure atmosphere of about several pascals, and a predetermined high-frequency electric power is applied between a pair of plate electrodes provided in the chamber, thereby forming plasma. Dry etching is performed by using the formed plasma. The Si substrate 16 is used in the resonator 10 according to the embodiment, but the invention is not limited to the Si substrate 16, and a semiconductor substrate other than the Si substrate may be used. However, the Si substrate 16 is preferably used, since the Si substrate 16 may be bonded anodically to the vibrating plate 12.

As described above, in the resonator 10, one of a pair of electrodes is formed by the Si substrate 16 being made conductive. In addition, a portion of the region 20 corresponding to the electrode is made thin by the recess 18 being formed. Thus, a resonator having an oscillation frequency of about 600 MHz may stably be produced. Further, joining of the Si substrate 16 and the vibrating plate 12 may be performed by anode bonding, and thus an extra layer is not formed between the Si substrate 16 and the vibrating plate 12 due to an adhesive or the like. As a result, an extra mass is not added to the vibrating plate 12, and hence a resonator having an oscillation frequency of about 600 MHz may stably be produced. In addition, the vibrating plate 12 is subjected to grinding in a state of being firmly joined to the Si substrate 16 by anode bonding, and hence the grinding may stably be performed.

Next, a method of producing the resonator 10 will be described. FIGs. 2A to 2E are diagrams illustrating the method of producing the resonator 10. First, as illustrated in FIG. 2A, the Si substrate 16 is prepared of which the region 20 is previously made conductive such that the region 20 serves as an electrode. The Si substrate 16 is joined to the vibrating plate 12. Specifically, the Si substrate 16 and the vibrating plate 12 are overlaid on each other, and with the vibrating plate 12 as a cathode and the Si substrate 16 as an anode, for example, a voltage of about 500 V to 1000 V is applied in an temperature atmosphere of 300°C to 400°C. By so doing, positive ions in the vibrating plate 12 forcibly move toward the cathode side, the Si substrate 16 and the vibrating plate 12 adhere to each other due to electrostatic attraction, and further the portions of the Si substrate 16 and the vibrating plate 12 that contact each other are joined to each other due to a chemical reaction.

Next, as illustrated in FIG. 2B, the joined vibrating plate 12 is subjected to mechanical grinding. Instead of mechanical grinding, dry etching or wet etching may be used. However, mechanical grinding is preferred since the surface of the vibrating plate 12 is uniformly and finely finished and an oscillation characteristic of a high Q value is provided. In mechanical grinding, for examples, rough grinding and finish grinding are performed by using an abrasive such as silicon carbide or aluminum oxide corundum. In the embodiment, since the vibrating plate 12 is joined to the Si substrate 16, the vibrating plate 12 may stably be ground to 3 µm or less by mechanical grinding. In the grinding operation, in order to prevent excessive grinding, for example, a laser beam is applied to the vibrating plate 12, and the vibrating plate 12 is ground such that the thickness of the vibrating plate 12 becomes a predetermined thickness, while the thickness of the ground vibrating plate 12 is measured with a laser interferometer,

Next, as illustrated in FIG. 2C, the electrode 14 is formed on the vibrating plate 12. The formation of the electrode 14 is performed by vacuum deposition or sputtering, The electrode 14 is formed, for example, with a thickness of several nanometers to 10 nanometers. The method of forming the electrode 14 is not particularly limited to a specific one, and a method other than vacuum deposition and sputtering may be used. However, vacuum deposition or sputtering is suitably used, since the mass of the electrode 14 is prevented from being high in order to suppress a decrease in the oscillation frequency of the vibrating plate 12.

Next, with respect to a surface (back surface) of the Si substrate 16 that is opposite to the vibrating plate 12, a region corresponding to the electrode 14 is etched. Thus, as illustrated in FIG. 2D, the recess 18 is formed in the back surface of the Si substrate 16. In the etching, for example, CF₄ is introduced into a chamber having a pressure atmosphere of about several pascals, and a predetermined high-frequency electric power is applied between a pair of plate electrodes arranged in parallel with each other, thereby forming plasma. Dry etching is performed by using the formed plasma. Dry etching is selectively performed by using a mask. Alternatively, wet etching also may be used instead of dry etching. However, as described below, dry etching is preferably performed, since etching is efficiently performed while monitoring is performed.

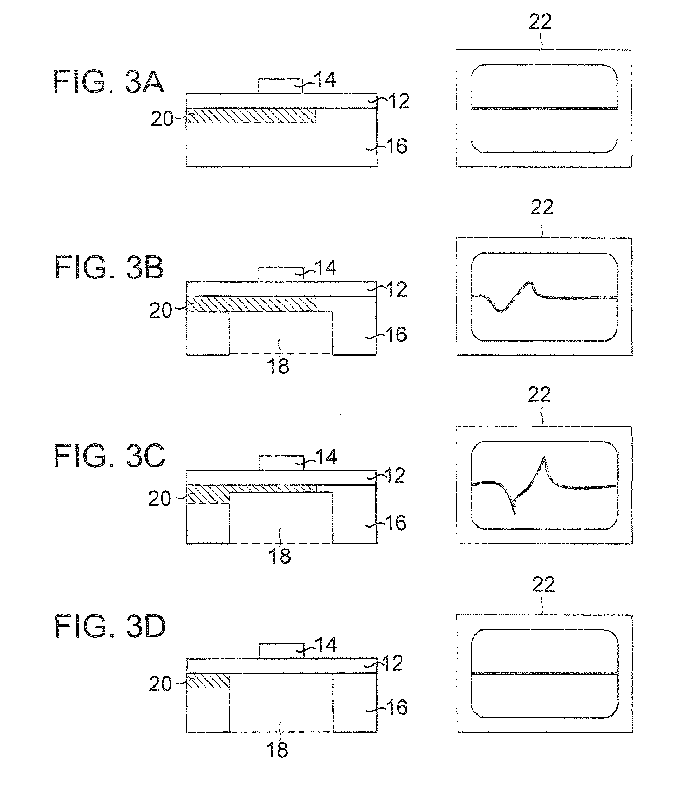

FIGs. 3A to 3D are diagrams illustrating monitoring of frequency characteristics of the resonator 10 that is performed in dry etching. As described above, the vibrating plate 12 and the electrode 14 are provided on the Si substrate 16, and even when a voltage is applied to the electrode 14 and the region 20 made conductive, oscillation does not occur as illustrated on the screen 22 in FIG. 3A. This is because the Si substrate 16 has a large thickness and a high rigidity, and hence the Si substrate 16 blocks the vibrating plate 12 from vibrating. At that time, in order to check impedance frequency characteristics obtained by applying a voltage to the electrode 14 and the region 20, monitoring is performed by using a frequency analyzer 22.

When the etching of the Si substrate 16 progresses, the recess 18 deepens, and the thickness of the Si substrate 16 at the bottom of the recess 18 is decreased to some extent, an impedance frequency characteristic appears as illustrated in the frequency analyzer 22 of FIG. 3B. This is because the Si substrate 16 becomes thin at the recess 18 and its rigidity decreases. However, desired frequency characteristics (oscillation frequency, Q value) are not achieved yet, and thus the etching is continued. Further, when the etching of the Si substrate 16 progresses, the recess 18 deepens, and a desired frequency characteristic is provided as illustrated in the frequency analyzer 22 of FIG. 3C, the etching is ended. When the etching is further progressed in this state, the region 20 in the Si substrate 16 is etched. At this time, the Si substrate 16 does not serve as an electrode any more. Thus, the resonator 10 does not vibrate, and the frequency characteristic disappears as illustrated in the frequency analyzer 22 of FIG. 3D.

As described above, it is preferred that the etching is controlled by monitoring the frequency characteristic of the impedance of the resonator 10 when the Si substrate 16 is etched to form the recess 18, from the standpoint that the resonator 10 having a desired frequency characteristic is produced.

Finally, as illustrated in FIG. 2E, the electrode 14 is etched as necessary. When a frequency characteristic of the impedance is not provided in a state illustrated in FIG. 3C, this etching is performed by thinning the electrode 14, in order to fine-tune the oscillation frequency. For the etching of the electrode 14, dry etching or wet etching is used. In order to perform accurate fine tuning, dry etching is preferably used. It is preferred if dry etching is performed while the frequency characteristic of the resonator 10 is monitored as illustrated in FIGs. 3A to 3D. Further, the vibrating plate 12 may be etched as necessary. By etching the vibrating plate 12, the oscillation frequency may also be fine-tuned.

Since the vibrating plate 12 is previously joined to the Si substrate 16 as described above, the grinding operation for decreasing the thickness of the vibrating plate 12 may stably and easily be performed. In addition, since a region of the surface of the Si substrate 16 that serves as an electrode (the surface opposite to the surface to which the vibrating plate 12 is joined) is etched, the thickness of the region 20 that vibrates with the vibrating plate 12 may be adjusted, and a resonator having an oscillation frequency of about 600 MHz may stably be produced. Moreover, since the frequency characteristic of the impedance is monitored when the Si substrate 16 is etched, a resonator having a targeted frequency characteristic also may efficiently be produced. Since the region 20 having a decreased thickness is made conductive to serve as an electrode, an increase in the oscillation frequency may be achieved.

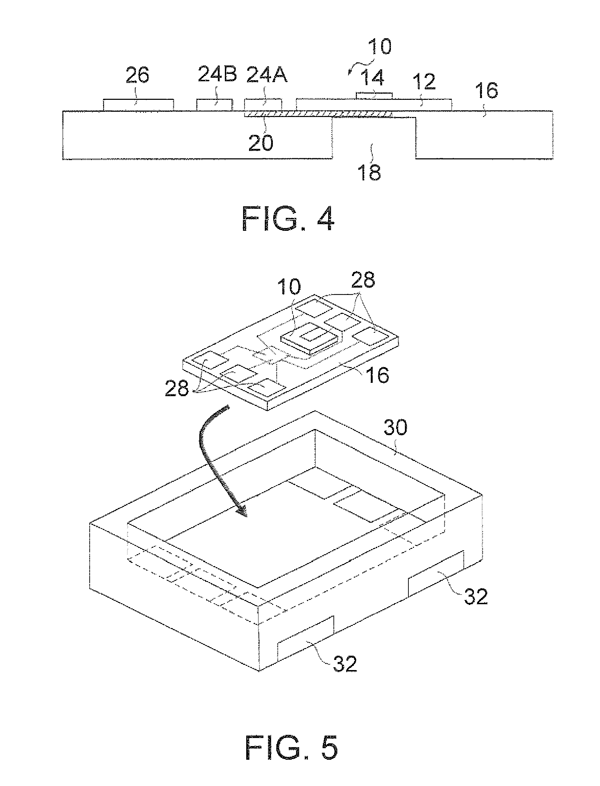

In the Si substrate 16 of the resonator 10 produced, an oscillation circuit 26 as illustrated in FIG. 4 and a control circuit (not illustrated) may be formed. The electrode 14 and the region 20 that serves as an opposite electrode opposed to the electrode 14 and that is made conductive are connected to terminals 24A and 24B, respectively, and are connected to the oscillation circuit 26 and the control circuit via the terminals 24A and 24B. In this manner, the resonator 10 is formed into one chip with the oscillation circuit 26, the control circuit, an output buffer, and the like on the Si substrate 16. As illustrated in FIG. 5, in a state of being formed into one chip, such a resonator 10 is integrally accommodated in a housing 30 with the oscillation circuit 26, the control circuit, the output buffer, and the like, and may be provided as a packaged oscillator. In other words, as illustrated in FIG. 5, the oscillation circuit may compactly be packaged. Other than the oscillation circuit, the control circuit, and the output buffer, a circuit that is accommodated with the resonator 10 in the housing 30 and packaged may be, for example, a PLL (Phase Locked Loop) circuit including a VCO (Voltage Controlled Oscillator), a phase comparator, a frequency divider, and the like. The packaged circuit is connected to a printed wiring board via terminals 32 and mounted thereon.

(Second embodiment)

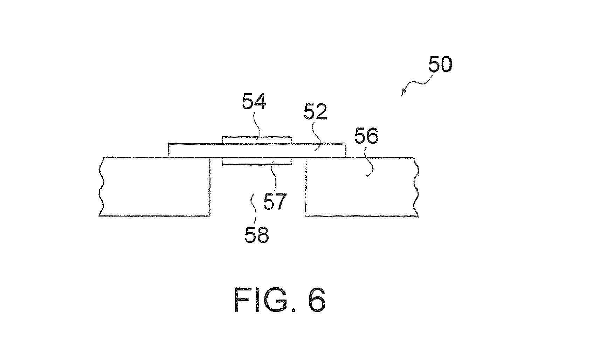

FIG. 6 is a diagram illustrating a configuration of a main portion of a resonator 50 according to a second embodiment. The resonator 50 includes a vibrating plate 52 that is an AT cut crystal (quartz) vibrating plate, an electrode 54, a Si substrate 56, and an opposite electrode 57. The vibrating plate 52 is joined to the silicon (Si) substrate 56, and the electrode 54 and the opposite electrode 57 are provided on the vibrating plate 52. The electrode 54 and the opposite electrode 57 are connected to terminals via connection lines not illustrated. The terminals are connected to an oscillation circuit, a control circuit, or the like. In the resonator 50, unlike the resonator 10 illustrated in FIG. 1, the Si substrate 56 has a through hole 58 around at a position where the vibrating plate 52 is joined to the Si substrate 56, and the vibrating plate 52 is exposed through the through hole 58. At a position in the through hole 58, the opposite electrode 57 is formed on the vibrating plate 52.

In production of such a resonator 50, unlike the resonator 10, the Si substrate 56 having no region 20 that is made conductive is used. The Si substrate 56 and the vibrating plate 52 are joined to each other. As the joining method, anode bonding is suitably used. However, the Si substrate 56 and the vibrating plate 52 may be joined to each other by a conductive adhesive or the like. Next, the vibrating plate 52 joined to the Si substrate 56 is ground by the same method as in the treatment illustrated in FIG. 2B. For the grinding, for example, mechanical grinding is used. Next, the electrode 54 is formed on the ground vibrating plate 52 by the same method as in the treatment illustrated in FIG. 2C. Then, the through hole 58 is formed in the Si substrate 56 by selective etching with a mask by the same method as in the treatment illustrated in FIG. 2D, whereby the vibrating plate 52 is exposed through the through hole 58. In the etching, since the vibrating plate 52 is a crystal plate made of SiO₂, when dry etching is performed on the Si substrate 56, the Si substrate 56 is not etched to the vibrating plate 52. Then, the electrode 57 is formed on the vibrating plate 52 exposed through the through hole 58, by using vacuum deposition or sputtering. In this manner, the resonator 50 may be produced.

In the produced resonator 50, as illustrated in FIG. 5, an oscillation circuit, a control circuit, and the like are formed on the Si substrate 56 on which the resonator 50 is produced, and are accommodated in a housing, whereby a packaged oscillator may be produced. With respect to such a resonator 50 as well, since the vibrating plate 52 is previously joined to the Si substrate 56 similarly to the resonator 10, the grinding operation for decreasing the thickness of the vibrating plate 52 may stably and easily be performed. In addition, since a predetermined region of the surface of the Si substrate 56 on a side where the vibrating plate 52 is not joined is etched, the resonator may stably and efficiently be produced. Further, since the resonator 50 is formed on the Si substrate 56 with other circuits, a packaged oscillator may be provided.

While the method of producing a resonator, the resonator, and the oscillator according to the present invention have been described in detail, the present invention is not limited to the embodiments described above, and various modifications and changes may be made without departing from the spirit of the present invention.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present inventions have been described in detail, it should be understood that the various changes, substitutions, and alterations could be made hereto without departing from the spirit and scope of the invention.

## Claims

1. A method of fabricating a resonator, comprising:
joining a vibrating plate with a substrate at a first surface of the substrate;
grinding a surface of the vibrating plate joined with the substrate;
forming an electrode on the ground surface of the vibrating plate; and
etching electively a region at a second surface of the substrate, the second surface being opposite to the first surface, the region corresponding to a position of the electrode.

2. The method according to claim 1, wherein the region is made electrically conductive to thereby serve as an opposite electrode opposing to the electrode.

3. The method according to claim 1, wherein the vibrating plate is a quartz resonator and the joining is performed by bonding anodically the vibrating plate with the substrate.

4. The method according to claim 2, wherein the vibrating plate is a quartz resonator and the joining is performed by bonding anodically the vibrating plate with the substrate.

5. The method according to claim 1, wherein the etching is performed to such a degree that the vibrating plate is exposed and an opposite electrode opposing to the electrode is formed on the exposed vibrating plate.

6. The method according to claim 1, further comprising monitoring for a characteristic of impedance of the resonator in order to control the etching when the etching is performed.

7. The method according to claim 2, further comprising monitoring for a characteristic of impedance of the resonator in order to control the etching when the etching is performed.

8. The method according to claim 3, further comprising monitoring for a characteristic of impedance of the resonator in order to control the etching when the etching is performed.

9. The method according to claim 4, further comprising monitoring for a characteristic of impedance of the resonator in order to control the etching when the etching is performed.

10. The method according to claim 5, further comprising monitoring for a characteristic of impedance of the resonator in order to control the etching when the etching is performed.

11. A resonator comprising:
a substrate including a first and a second surfaces opposite to each other, the first surface including a recess;
a vibrating plate bonded to a region of the second surface, the region formed at a position opposing to a position of the recess; and
an electrode formed on the vibrating plate,
wherein a portion of the substrate at a bottom of the recess is made to be electrically conductive and serves as an opposite electrode opposing to the electrode.

12. A resonator comprising:
a substrate including a through hole;
a vibrating plate formed on a surface of the substrate so as to cover an end of the through hole;
a first electrode formed on the vibrating plate; and
a second electrode formed on a portion of the vibrating plate so as to oppose to the first electrode, the portion exposed through the through hole.

13. The resonator according to claim 11, wherein the substrate is made of silicon, the vibrating plate is made of quartz, and the substrate and the vibrating plate are joined with each other by anodic bonding.

14. The resonator according to claim 12, wherein the substrate is made of silicon, the vibrating plate is made of quartz, and the substrate and the vibrating plate are joined with each other by anodic bonding.

15. An oscillator comprising:
a resonator including;
a semiconductor substrate including a first and a second surfaces opposite to each other, the first surface including a recess,
a vibrating plate bonded to a region of the second surface, the region formed at a position opposing to a position of the recess, and
an electrode formed on the vibrating plate,
wherein a portion of the substrate at a bottom of the recess is made to be electrically conductive and serves as an opposite electrode opposing to the electrode,
an oscillation circuit formed on the semiconductor substrate for oscillating the resonator; and
a housing for covering the resonator and the oscillation circuit.

16. An oscillator comprising:
a resonator including;
a semiconductor substrate including a through hole,
a vibrating plate formed on a surface of the semiconductor substrate so as to cover an end of the through hole,
a first electrode formed on the vibrating plate, and
a second electrode formed on a portion of the vibrating plate so as to oppose to the first electrode, the portion exposed through the through hole;
an oscillation circuit formed on the semiconductor substrate for oscillating the resonator; and
a housing for covering the resonator and the oscillation circuit.
